# EUROPÄISCHE PATENTSCHRIFT

(11) **EP 3 755 923 B1**
(45) Veröffentlichungstag und Bekanntmachung des Hinweises auf die Patenterteilung: **22.06.2022**
(21) Anmeldenummer: 19708962.6
(22) Anmeldetag: 20.02.2019
(51) Int. Cl.: F16G 13/16

(54) **ÜBERWACHUNGSSYSTEM FÜR ENERGIEFÜHRUNGSKETTEN**
MONITORING SYSTEM FOR CABLE DRAG CHAINS
SYSTÈME DE SURVEILLANCE POUR CHAÎNES PORTE-CÂBLES

(30) Priorität: 21.02.2018 DE 202018100962 U
(43) Veröffentlichungstag der Anmeldung: 30.12.2020
(73) Patentinhaber: Igus GmbH, 51147 Köln (DE)
(72) Erfinder: JAEKER, Thilo-Alexander, 53757 Sankt Augustin (DE); BARTEN, Dominik, 53340 Meckenheim (DE)
(74) Vertreter: Lippert Stachow Patentanwälte Rechtsanwälte
(86) Internationale Anmeldenummer: PCT/EP2019/054247
(87) Internationale Veröffentlichungsnummer: WO 2019/162347

(56) Entgegenhaltungen:
- WO-A1-2015/118143
- DE-U1-202004 005 858
- JP-A- 2000 102 153
- JP-A- 2009 052 714
- JP-U- S5 580 554

## Beschreibung

Die Erfindung betrifft allgemein eine Energieführungskette zur dynamischen Führung einer oder mehrerer Leitungen, wie Kabel, Schläuche oder dergleichen, zwischen einer Basis an einem Ende der Energieführungskette und einem relativ zur Basis beweglichen Mitnehmer am anderen Ende der Energieführungskette. Die Energieführungskette hat dabei eine Vielzahl miteinander verbundener Glieder bzw. Segmente, wobei die Glieder bzw. Segmente zur Bildung eines Umlenkbogens gegeneinander abwinkelbar sind. Die Erfindung betrifft weiterhin einen Bausatz zum Nachrüsten einer Energieführungskette zwecks Überwachung und ein Überwachungssystem für eine Energieführungskette.

Während des Betriebes einer Energieführungskette kann es zu Störungen des Betriebszustandes kommen, die ein Fehlverhalten der Energieführungskette verursachen können. Eine Energieführungskette kann durch äußere Einwirkung beschädigt werden, z.B. durch Gegenstände, die in den Verfahrweg der Energieführungskette gelangen und das ordnungsgemäße Verfahren der Kette blockieren können. Wenn der Mitnehmer im Falle solcher Störung die Glieder der Kette unter Druckbelastung vor sich herschiebt, kann es zu einem Abwinkeln der Glieder bzw. Segmente gegen die gewünschte Abwinkelungsrichtung der Glieder, welche zur Bildung des Umlenkbogens vorgesehen ist, kommen. Dabei kann es insbesondere in dem an dem Mitnehmer anschließenden Abschnitt der Kette zur Ausbildung eines vom ordnungsgemäßen Verfahrweg abweichenden Bogens bis hin zu einem teilweisen oder vollständigen Bruch der Kette kommen. Ferner kann es zu einem Schaden wie einem Bruch in einem Kettenglied bzw. Segment durch äußere Einwirkung oder Verschleiß der Kette kommen. Ein Fortsetzen des Betriebes der Energieführungskette nach einer solchen Störung kann eine Beschädigung oder sogar einen Abriss der geführten Leitungen zur Folge haben. Durch eine frühzeitige Erkennung eines Fehlverhaltens der Energieführungskette kann der Betrieb der Kette angehalten und die Störung beseitigt werden. Bei einem Bruch eines Gliedes oder Segmentes der Kette können die beschädigten Teile ausgetauscht oder repariert werden.

Demzufolge muss ein Fehlverhalten der Energieführungskette schnellstmöglich erkannt werden, um eine Beschädigung der geführten Leitungen und sogar Maschinen, die sie versorgen, zu vermeiden.

Einerseits sind bereits verschiedene Ansätze vorgeschlagen worden, um einen Bruch in einer Energieführungskette zu erkennen:
In EP°1 521 015°A2 wird ein Bruchelement in Form einer elektrischen Leitung vorgeschlagen, die entlang einer Außenseite der Energieführungskette angebracht ist und an Gelenkzapfen der Glieder fixiert ist. Im Falle eines Kettenbruchs bricht die Detektionsleitung ebenfalls, was ein Anhalten der Kette bewirkt. Wenn die Kette repariert ist, muss auch die elektrische Leitung erneuert und entlang der gesamten Kette aufwendig neu eingezogen werden.

In JP°2009-052714°A wird zur Detektion eines Kettenbruchs ein System vorgeschlagen, bei dem ein optisches Kabel entlang einer Außenseite einer Energieführungskette befestigt wird und das Licht, das durch das Kabel geleitet wird, durch einen Detektor gemessen wird. Bei einem Bruch in einem der Kettenglieder wirkt das System ähnlich dem vorgenannten System und erfordert aufwendige Instandsetzung.

In WO°2015/118143°A1 wird hingegen eine Energieführungskette mit einer dehnungsarmen flexiblen Auslöseschnur als Detektionsleitung vorgeschlagen, die auf der Höhe der neutralen Faser der Energieführungskette geführt wird. Die Auslöseschnur wirkt mit einem mechanischen Detektor zusammen zur Erfassung eines Bruchs der Kette. Bei einem Bruch der Kette ändert sich die Position eines Aufnehmers in Längsrichtung der Kette, was durch den Detektor erfasst wird. Eine Erneuerung der Auslöseschnur ist nach einem Bruch in der Regel nicht erforderlich.

Andererseits sind auch bereits Lösungen bekannt, um speziell einen nicht bestimmungsgemäßen Verlauf einer Energieführungskette, bei dem es nicht bzw. noch nicht zu einem Kettenbruch gekommen ist, zu erkennen:
Beispielweise beschreibt DE°20 2004 005 858°U1 eine Lösung, bei der Kettenglieder mit jeweils einer Registriereinrichtung vorgesehen sind, die in der Lage ist, ein Verschwenken eines Kettenglieds, das über einen normalen Winkelbereich hinausgeht, zu detektieren. Die Registriereinrichtung weist Schaltermittel auf, die bei einem Verschwenken des Kettenglieds aus seiner Normalanordnung über den vorbestimmten Winkelbereich hinaus von einem ersten Schalterzustand in einen zweiten Schalterzustand umschalten, was die Registriereinrichtung detektiert. Diese Lösung hat sich zwar bewährt, ist allerdings recht aufwendig. Die WO2015/118143 A1 offenbart eine Energieführungskette mit einem Schutz gegen Leitungsabriss. Die Schutzausrüstung umfasst einen Detektor, welcher zur Überwachung der Energieführungskette vorgesehen ist. Der Detektor ist mechanisch mit einer dehnungsarmen Auslöseschnur wirkverbunden und hat einen Aufnehmer zur Erfassung eines kinematischen Parameters der Auslöseschnur. Durch Veränderung des kinematischen Parameters kann ein Bruch der Energieführungskette rechtzeitig erkannt werden. Die JP2009052714A offenbart eine weitere Energieführungskette mit einer ähnlichen Detektionsausrüstung.

Eine Aufgabe der vorliegenden Erfindung ist es, eine einfache und dennoch robuste Lösung vorzuschlagen. Die Lösung soll zudem wahlweise für die Detektion eines Bruchs in einer

Energieführungskette oder für die Detektion eines nicht bestimmungsgemäßen Verlaufs oder auch für die Detektion der beiden vorgenannten Arten von Fehlverhalten einer Energieführungskette geeignet sein.

Als eine Lösung der genannten Aufgabe wird eine Energieführungskette mit den Merkmalen des Anspruchs 1 vorgeschlagen. Vorteilhafte Ausführungsformen sind Gegenstand der Unteransprüche. Ein erfindungsgemäßer Bausatz zum Nachrüsten einer Energieführungskette bzw. ein erfindungsgemäßes Überwachungssystem für eine Energieführungskette sind in den nebengeordneten Ansprüchen 16 bzw. 18 beansprucht.

Eine gattungsgemäße Energieführungskette umfasst eine Vielzahl miteinander verbundener Glieder bzw. Segmente zur Führung einer oder mehrerer Leitungen, wie Kabel, Schläuche oder dergleichen, zwischen einer Basis an einem Ende der Energieführungskette und einem relativ zur Basis beweglichen Mitnehmer am anderen Ende der Energieführungskette, wobei die Glieder bzw. Segmente zur Bildung eines Umlenkbogens gegeneinander abwinkelbar sind. Die gattungsgemäße Energieführungskette ist dabei mit einer Detektionsleitung ausgestattet, die eigens bzw. bestimmungsgemäß zum Erfassen eines Fehlverhaltens der Energieführungskette vorgesehen und im Wesentlichen auf Höhe der neutralen Faser der Energieführungskette angeordnet ist.

Erfindungsgemäß ist dabei die Detektionsleitung aus einer Mehrzahl einzelner Leitungs-Längsabschnitte zusammengesetzt, welche durch lösbare Verbindungen leitend miteinander verbunden sind, sodass ein Fehlverhalten der Energieführungskette zum leitungsunterbrechenden Auftrennen mindestens einer der Verbindungen führt und die daraus resultierende Leitungsunterbrechung mit einem Detektor erfassbar ist. Die Detektionsleitung besteht also bzgl. ihrer Längsrichtung aus einer Anzahl einzelner Leitungsabschnitte. Sie muss dabei nicht über die Gesamtlänge der Energieführungskette vorgesehen sein, sondern sollte zumindest über eine relevante Teillänge der Energieführungskette vorliegen. Sie kann insbesondere über eine Länge entsprechend dem Bewegungsbereich des Umlenkbogens vorgesehen werden.

Die Detektionsleitung ist eine separat bzw. bestimmungsgemäß zur Überwachung vorgesehene bzw. dedizierte Leitung, d.h. diese ist zum Erfassen eines Fehlverhaltens der Energieführungskette bestimmt. Die Detektionsleitung entspricht somit nicht einer der Leitungen, welche als Versorgungsleitungen für die gewünschte Anwendung dynamisch von der Energieführungskette geführt werden. Die Detektionsleitung muss somit endseitig z.B. nicht aus der Energieführungskette herausgeführt sein. Die Detektionsleitung kann jedoch Bestandteile umfassen, die auch weitere Funktionen in der Energieführungskette erfüllen können, bspw. Trennstege.

Die Detektionsleitung kann also über eine Länge entsprechend dem Bereich, über welchen der Umlenkbogen sich infolge der Mitnehmerbewegung bewegt, aus einzelnen Leitungsabschnitten zusammengesetzt sein, welche lösbar miteinander verbunden sind, um in diesem Bereich eine mehrteilige aber in Bezug auf das verwendete Detektionsmedium durchgehend leitende Leitung zu bilden. Die Detektionsleitung kann dabei z.B. ein Detektionsmedium bzw. ein Signal leiten, wenn die Detektionsleitung intakt ist. Ein Detektor kann an die Detektionsleitung angeschlossen sein, um das Detektionsmedium bzw. das Signal zu überwachen und z.B. eine Veränderung gegenüber dem Sollzustand bei intakter Detektionsleitung zu detektieren.

Bei einem Versagen der Energieführungskette kann es insbesondere zu einem Auftrennen von mindestens einer der lösbaren Verbindungen zwischen zwei aufeinanderfolgenden Leitungsabschnitten kommen, d.h. zum Verlust der Integrität der Detektionsleitung. Dadurch kommt es inhärent zu einer messbaren Zustands- oder Signalveränderung, die an der Detektionsleitung messbar ist. Die einzelnen Verbindungen können dabei also bestimmungsgemäß wie lösbare, insbesondere zerstörungsfrei lösbare, Sollbruchstellen wirken.

Ein Vorteil der erfindungsgemäßen Lösung liegt darin, dass auch die Detektionsleitung im Falle eines Fehlverhaltens oder auch eines Fehlalarms schnell repariert werden kann. Die Integrität der Detektionsleitung kann ohne Austausch schnell wiederhergestellt werden, indem die zuvor aufgetrennte Verbindung wieder hergestellt wird. Außerdem wird gegenüber fest verlegten durchgehenden Leitungen im Bedarfsfall auch die Instandsetzung der Energieführungskette, z.B. durch Austausch von Teilen der Energieführungskette, z.B. eines Kettenglieds, vereinfacht, wenn die Detektionsleitung bedarfsweise aufgetrennt und wiederhergestellt werden kann. Durchgehende an den Kettengliedern angebrachte Detektionsleitungen würden, je nach Bauart, eine Instandsetzung z.T. erheblich erschweren.

Hinsichtlich der Begriffe bedeutet ein Umlenkbogen hier ein Bereich einer Energieführungskette, in welchem sich der Verlauf bzw. die Richtung der Bewegung der Glieder bzw. Segmente ändert, z.B. um ca. 180° umkehrt. Benachbarte Glieder bzw. Segmente im Bereich des Umlenkbogens sind gegeneinander in eine gewünschte "Vorwärtsrichtung" abgewinkelt, d.h. deren Längsachsen (parallel zur Kettenlängsrichtung) kreuzen einander unter einem Winkel, der kleiner als 180° ist. Beim Verfahren der Energieführungskette verfährt der Umlenkbogen mit, d.h. jeweils andere Glieder bzw. Segmente bilden den Umlenkbogen. Der Begriff Glieder bezieht sich auf eine echte Gliederkette aus einzelnen Gliedern. Die Erfindung ist allgemein auf aktive Leitungsführungen anwendbar, z.B. solche mit abschnittsweise oder vollständig durchgehenden flexiblen Bändern, mit welchen Segmente zur Führung der Leitung abwinkelbar verbunden oder einteilig hergestellt sind. Die neutrale Faser, auch Nulllinie genannt, entspricht der Schicht des Querschnitts der Energieführungskette, deren Länge sich bei der Abwinkelung bzw. beim Verfahren des Umlenkbogens nicht ändert. Auf dieser Querschnittslage werden geführte Leitungen der geringsten Zug-/ Schub-Belastung durch die Umlenkung ausgesetzt.

Die lösbaren Verbindungen, durch welche die Leitungsabschnitte miteinander verbunden sind können als Steckverbindungen ausgeführt sein, dies gilt für alle aber zumindest die Mehrzahl der lösbaren Verbindungen. So kann die Detektionsleitung in einfacher Weise aus einzelnen Leitungsabschnitten zusammengesetzt werden. Auch nach einer Leitungsunterbrechung der Detektionsleitung im Falle eines Fehlverhaltens der Energieführungskette kann die Integrität der Detektionsleitung durch Zusammenstecken der Leitungsabschnitte unkompliziert und schnell wiederhergestellt werden.

Die Steckverbindungen können insbesondere als in Leitungslängsrichtung steckbare Steckverbindungen ausgeführt sein.

Die Längsrichtung der Detektionsleitung entspricht der Längsrichtung der anderen bzw. geführten Leitungen, die durch die Energieführungskette von einer Basis zu einem Mitnehmer geführt werden bzw. der Verlaufrichtung der Energieführungskette. In einer Ausführungsform kann zu jeder lösbaren Verbindung zwischen zwei aufeinanderfolgenden Leitungsabschnitten jeweils mindestens ein Verbinder vorgesehen sein. Der bzw. die Verbinder können vorzugsweise durch einen Halter an einem Glied bzw. Segment gehalten sein um eine Sollposition in Längsrichtung vorzugeben. Der Halter kann dabei den Verbinder auch auf der Höhe der neutralen Faser positionieren. Vorteilhaft dabei ist eine zuverlässige Positionierung der Detektionsleitung auf der Höhe der neutralen Faser. Verschiedene Ausgestaltungen der Halter sind möglich.

Über eine Teillänge der Energieführungskette, zumindest über das erste, dem Mitnehmer am nächsten liegende Drittel der Länge der Energieführungskette, sollte die Detektionsleitung vorgesehen sein.

Es sollte zumindest über eine bzgl. Fehlverhalten kritische Teillänge an jedem zweiten Glied bzw. Segment, vorzugsweise an jedem Glied bzw. Segment, jeweils eine lösbare Verbindung zum leitenden Verbinden von zwei Leitungsabschnitten mechanisch gehalten sein, vorzugsweise auf Höhe der neutralen Faser. Die Verbindung zwischen jeweils zwei aufeinanderfolgenden Leitungsabschnitten kann dabei in Längsrichtung der Energieführungskette zu einem gewissen Grad beweglich oder auch festgelegt sein.

In einer Ausführungsform kann der Verbinder durch den Halter an dem Glied bzw. Segment in Längsrichtung der Energieführungskette arretiert bzw. festgelegt sein, d.h., der Verbinder kann so an dem Glied bzw. Segment gehalten sein, dass in Längsrichtung keine nennenswerte Verschiebung des Verbinders relativ zu dem Glied bzw. Segment der Energieführungskette ohne Auftrennen der Verbindung zwischen zwei aufeinanderfolgenden Leitungsabschnitten möglich ist. Der Verbinder kann dabei fest an dem Glied/Segment gehalten, insbesondere befestigt, oder lösbar gehalten sein. Vorteilhaft dabei ist es, dass ein Fehlverhalten der Kette zwischen jeweils zwei Gliedern bzw. Segmenten der Energieführungskette, an denen ein Leitungsabschnitt endseitig durch zwei Verbinder arretiert ist, zur Trennung mindestens einer der zwei Verbindungen führen wird und so detektiert werden kann.

Jeder Leitungsabschnitt der Detektionsleitung kann in einer besonders bevorzugten Ausführungsform als Druckschlauchabschnitt für ein Druckmedium, insbesondere als pneumatischer Druckschlauchabschnitt für Druckluft, ausgebildet sein. Dabei kann jeder Verbinder als pneumatisches Kupplungsstück ausgebildet sein, das einen Kanal für das Druckmedium aufweist und beidseitig in Längsrichtung der Energieführungskette mit zwei Schlauchtüllen ausgestattet ist, die jeweils - im Sinne einer Druckluft-Schlauchtülle bzw. - Schlauchanschlusses - eine lösbare Steck-Verbindung mit einem Druckschlauchabschnitt erlauben, sodass jedes der Kupplungsstücke eine leitende Verbindung zweier Druckschlauchabschnitte bereitstellen kann. Besonders vorteilhaft bei dieser Ausführungsform ist, dass handelsübliche Druckschläuche z.B. in NW 7,2 mm Standard-Ausführung eine preiswerte Variante für eine Detektionsleitung darstellen. Druckluft stellt zudem i.d.R. keine Störquelle für die geführten Leitungen dar.

Jeder Druckschlauchabschnitt kann also vorzugsweise als pneumatischer Druckschlauchabschnitt ausgebildet sein, und jedes Kupplungsstück kann durch einen Halter, insbesondere in Form eines Trennstegs, auf der Höhe der neutralen Faser gehalten werden. Das Kupplungsstück kann, z.B. mit seinen Schlauchtüllen, insbesondere einstückig, mit dem Trennsteg ausgeführt sein bzw. als Teil des Trennstegs ausgebildet sein. Diese Ausführungsform stellt eine vorteilhafte Variante dar, bei der die Detektionsleitung einfach nachgerüstet und auch nach einer Trennung einer der Verbindungen der Leitungsabschnitte besonders einfach repariert werden kann. Es ist auch eine Ausführungsform denkbar, bei der jeweils ein Druckschlauchabschnitte fest mit je einem Trennsteg verbunden ist bzw. eine Baugruppe bildet, wobei die leitende Verbindungen zwischen solchen Baugruppen als Steckverbindungen von jeweils zwei Druckschlauchabschnitten ausgeführt sind.

In einer alternativen Ausführungsform der Energieführungskette kann jeder Leitungsabschnitt der Detektionsleitung einen elektrischen Leiter umfassen und die Verbindungen können jeweils durch geeignete elektrische Steckverbinder ausgeführt sein, insbesondere durch je zwei konjugierte Steckverbinder. Bei vordefinierter Kraft lösbare Steckverbinder sind nicht nur für pneumatische Leitungssysteme, sondern auch für elektrische Leitungen handelsüblich und preiswert erhältlich.

Vorzugsweise weisen jeweils benachbarten Leitungsabschnitte in etwa gleiche Leitfähigkeit auf. Gleiche Leitfähigkeit kann z.B. störende Reflektion des Detektionsmediums verringern.

Alternativ, aber weniger bevorzugt, könnte jeder Leitungsabschnitt einen optischen Leiter umfassen, und die Verbindungen können jeweils durch zwei optische Steckverbinder ausgeführt sein.

Jeder Steckverbinder kann durch jeweils einen Halter, insbesondere in Form eines Trennstegs, auf der Höhe der neutralen Faser festgehalten werden. Dazu kann der Halter eine Aufnahme aufweisen, die passend zu dem Steckverbinder ausgebildet ist, sodass jeder der Halter jeweils eine leitende Verbindung zweier Leitungsabschnitte an vorgegebener Stelle in Längsrichtung halten kann. Die Aufnahmen können so ausgeführt sein, dass die Steckverbinder in den Aufnahmen in Längsrichtung der Energieführungskette arretiert sind. Vorteilhaft dabei ist es, dass ein Fehlverhalten der Kette zwischen jeweils zwei Aufnahmen zur Trennung der bestimmungsgemäß lösbaren Verbindung der zwei Leitungsabschnitte führen kann.

Die Zugfestigkeit der lösbaren Verbindung jeweils zweier Leitungsabschnitte ist vorzugsweise geringer, als die Zugfestigkeit dieser Leitungsabschnitte.

Sollte die Detektionsleitung im Falle eines Fehlverhaltens der Energieführungskette auf Zug beansprucht werden und eine oder mehrere der Verbindungen sich dadurch lösen, blieben die Leitungsabschnitte dadurch an sich unbeschädigt, d.h. können wieder verbunden werden, um die Detektionsleitung wiederherzustellen.

Die lösbaren Verbindungen sind vorzugsweise zerstörungsfrei lösbar, insbesondere lösbar ohne Zerstörung eines der durch diese verbundenen Leitungsabschnitte, sodass die Integrität der Detektionsleitung ohne Austausch der Leitungsabschnitte schnell wiederhergestellt werden kann.

Die Verbindungen sind vorzugsweise bei einer vordefinierten Kraft lösbar. Diese Kraft kann bspw. je nach Art der geführten Leitungen, zu deren Führung die Energieführungskette dient, und je nach Bauweise der Kette passend gewählt werden, sodass diese lösbaren Verbindungen nicht im Normalbetrieb, jedoch bei Fehlverhalten der Energieführungskette aufgetrennt werden. So kann bei Bedarf eine robuste Detektionsleitung bereitgestellt werden, die bei geringeren Beanspruchungen intakt bleiben kann.

In einer Ausführungsform können zumindest einige der Halter jeweils einen in Längsrichtung der Energieführungskette vorstehenden Hebelvorsprung aufweisen, der so ausgebildet und angeordnet ist, dass bei einem unerwünschten Abwinkeln der Glieder bzw. Segmente der Energieführungskette gegen die ordnungsgemäße Abwinkelungsrichtung der Hebelvorsprung mit dem benachbarten Leitungsabschnitt zusammenwirken kann, um dessen Verbindung zum nächsten Leitungsabschnitt zu trennen. Die ordnungsgemäße Abwinkelungsrichtung ist dabei die zur Bildung des Umlenkbogens gewünschte Richtung. Diese Ausführungsform ist besonders vorteilhaft, um einen nicht bestimmungsgemäßen Verlauf der Energieführungskette zu erkennen. Bei Überbiegen der Energieführungskette, d.h. übermäßigem Abwinkeln der Glieder bzw. Segmente gegen die ordnungsgemäße Abwinkelungsrichtung, kann der Hebelvorsprung mit dem zugeordneten Leitungsabschnitt in Kontakt kommen und auf diesen so einwirken, dass dessen Verbindung zu dem nächsten Leitungsabschnitt getrennt wird.

Mindestens einige Leitungsabschnitte der Detektionsleitung, vorzugsweise jeder Leitungsabschnitt, kann endseitig an einem von zwei benachbarten Gliedern bzw. Segmenten der Energieführungskette lösbar befestigt sein. Dadurch kann die Befestigung bei einem Fehlverhalten der Energieführungskette von selbst gelöst werden, ggf. auch ohne zusätzliche Hilfsmittel, wie z.B. Hebelvorsprünge. In einer Ausführungsform können an jedem Glied bzw. Segment der Energieführungskette je zwei aufeinanderfolgende Leitungsabschnitte jeweils mit einem ihrer zwei Enden lösbar befestigt sein, insbesondere indem dort das als Verbinder dienende Bauteil gehalten wird oder integriert ist. Die zwei Leitungsabschnitte können dabei mit dem jeweils anderen Ende an einem jeweils benachbarten Glied bzw. Segment der Energieführungskette lösbar befestigt sein.

In einer Ausführungsform kann die Detektionsleitung eine Schlaufe entlang zumindest einer Teillänge der Energieführungskette bilden und von einem Ende der Energieführungskette ausgehend zu diesem Ende zurückgeführt sein. Diese Ausführungsform bietet den konstruktiven Vorteil, dass Anschlussstellen der Detektionsleitung z.B. für eine Quelle und für den Detektor an ein und demselben Ende der Energieführungskette angeordnet werden können, d.h. eine einfachere Konstruktion.

Die Energieführungskette kann Glieder bzw. Segmente mit einem Aufnahmeraum zur Aufnahme der geführten Leitungen umfassen, der durch jeweils mindestens eine Seitenlasche, typisch durch zwei parallel gegenüberliegende Seitenlaschen, begrenzt wird, wobei die Seitenlaschen in Längsrichtung der Energieführungskette schwenkbar miteinander verbunden sind und mindestens einen Laschenstrang bilden. Die Detektionsleitung, insbesondere deren Schlaufe, kann dabei in dem Aufnahmeraum, vorzugsweise seitlich außen zum Aufnahmeraum an dem Laschenstrang angeordnet sein. Die Detektionsleitung kann als Schlaufe an einem Laschenstrang angeordnet sein. Die Detektionsleitung kann an der Innenseite des Laschenstrangs angeordnet sein, also an der Seite, die dem Aufnahmeraum der Glieder bzw. Segmente der Energieführungskette zugewandt ist. Alternativ, kann die Detektionsleitung auch an der Außenseite des Laschenstrangs angeordnet sein.

In einer weit verbreiteten Ausführungsform können die Seitenlaschen z.B. durch konventionelle Aufnahme-Bolzen Verbindung in Längsrichtung der Energieführungskette schwenkbar miteinander verbunden sein. Auch andere Gelenkverbindungen, z.B. durch biegsame Gelenkelemente liegen aber im Rahmen der Erfindung.

Die Erfindung betrifft ferner einen Bausatz zum Nachrüsten einer Energieführungskette mit einer bestimmungsgemäßen Detektionsleitung zum Erfassen eines Fehlverhaltens der Energieführungskette, umfassend
- eine Mehrzahl einzelner Leitungsabschnitte, welche durch lösbare Verbindungen zu einer Detektionsleitung leitend miteinander verbindbar sind,;
- Verbinder zum Herstellen der lösbaren Verbindungen zwischen den Leitungsabschnitten; und
- Halter zum Anordnen der Detektionsleitung auf Höhe der neutralen Faser der Energieführungskette zumindest über eine Teillänge der Energieführungskette, insbesondere über eine Länge entsprechend dem Bewegungsbereich des Umlenkbogens.

Im Sinne der Erfindung führt dabei ein Fehlverhalten der Energieführungskette zum leitungsunterbrechenden Auftrennen mindestens einer der Verbindungen sodass die resultierende Leitungsunterbrechung mit einem Detektor erfasst werden kann. Insbesondere können dabei Trennstege als Halter verwendet werden. Trennstege sind typisch so ausgebildet, dass sie auf geeignete Art an Gliedern bzw. Segmenten der Energieführungskette angebracht werden können, d.h., die Energieführungskette kann mit solchen Trennstegen leicht nachgerüstet werden.

Ferner betrifft die Erfindung ein Überwachungssystem für eine Energieführungskette, umfassend
- eine Detektionsleitung, die aus einer Mehrzahl einzelner Leitungsabschnitte zusammengesetzt ist, welche durch lösbare Verbindungen leitend miteinander verbunden sind, um bei Fehlverhalten der Energieführungskette - durch leitungsunterbrechendes Auftrennen mindestens einer dieser Verbindungen ähnlich einer "Sollbruchstelle" - die resultierende Leitungsunterbrechung mit einem Detektor erfassbar zu machen;
- eine Anzahl Halter zum Anordnen der Detektionsleitung, insbesondere auf Höhe der neutralen Faser und zumindest über eine Teillänge der Energieführungskette, insbesondere über eine Länge entsprechend dem Bewegungsbereich des Umlenkbogens;
- mindestens eine Quelle für ein Detektionsmedium, wobei die Quelle leitend mit der Detektionsleitung verbunden ist, um das Detektionsmedium in die Detektionsleitung einzuspeisen;
- einen Detektor, der mit der Detektionsleitung in Verbindung steht, um eine bestimmungsgemäße Soll-Unterbrechung der Detektionsleitung bei Fehlverhalten zu detektieren; und
- eine Auswerteeinheit, mit welcher der Detektor signalübertragend verbunden ist.

In einer bevorzugten Ausführungsform kann die Quelle Druckluft in die Detektionsleitung einspeisen und der Detektor als Drucksensor ausgebildet sein. Die Anwesenheit eines vorgegebenen Nominal-Drucks in der Detektionsleitung kann für den Detektor als Signal der Integrität der Detektionsleitung dienen. Alternativ kann die Quelle z.B. elektrische Spannung für die Detektionsleitung bereitstellen und der Detektor zum Messen einer elektrischen Spannung ausgebildet sein. Der Betrag der elektrischen Spannung an der Detektionsleitung kann für den Detektor als Signal der Integrität der Detektionsleitung dienen. Die Anwesenheit des optischen Signals, das durch die Detektionsleitung zu dem Detektor übertragen wird, kann für den Detektor als Signal der Integrität der Detektionsleitung dienen.

Die Auswerteeinheit kann dazu ausgebildet sein, ein Fehlverhalten der Energieführungskette zu erkennen, wenn der Detektor eine Unterbrechung der Detektionsleitung detektiert, z.B. um einen Nothalt des Mitnehmers der Energieführungskette oder andere Schutzmaßnahmen auszulösen. Die Auswerteeinheit kann dazu ausgebildet sein, ein Signal zum Anhalten des Mitnehmers an eine Maschinen- oder Anlagensteuerung zu senden. Eine geeignet programmierbare Auswerteeinheit wird z.B. von der Anmelderin unter der Handelsbezeichnung "Auswerteeinheit PPDS.EU.01.SMD" angeboten.

Die Halter können als separate mit den Gliedern bzw. Segmenten der Energieführungskette verbindbare Bauteile, insbesondere als Trennstege, ausgebildet sein. Diese Ausführungsform ist vorteilhaft zum Nachrüsten einer Energieführungskette mit einer Detektionsleitung. Alternativ können geeignete Halter z.B. einstückig mit anderen Bauteilen der Energieführungskette ausgebildet sein oder auf andere Weise nachträglich an der Energieführungskette, z.B. an den Seitenlaschen, angebracht werden.

Die lösbaren Verbindungen, durch welche die einzelnen Leitungsabschnitte miteinander verbunden sind, sind vorzugsweise als Steckverbindungen ausgeführt. Die Verbindungen können hierdurch z.B. insbesondere erst bei Einwirkung einer vordefinierten Kraft gelöst werden und/oder leicht wiederhergestellt werden.

Weitere Einzelheiten, Vorteile und Merkmale der Erfindung lassen sich - ohne Beschränkung - dem nachfolgenden Teil der Beschreibung entnehmen, in welchem Ausführungsbeispiele der Erfindung anhand der beigefügten Zeichnungen näher erläutert werden. Bauteile mit äquivalenter Funktion bzw. Bauweise sind mit entsprechenden Bezugszeichen versehen. Es zeigen:
- FIG.1a:: ein erstes Ausführungsbeispiel einer Energieführungskette mit einer pneumatischen Detektionsleitung, gezeigt in einem Längsschnitt;
- FIG.1b: eine Vergrößerung aus FIG.1a (Bereich N);
- FIG.1c: eine perspektivische Ansicht eines Trennstegs der Energieführungskette nach FIG.1a;
- FIG.1d: eine Frontansicht des Trennstegs nach FIG.1c;
- FIG.2a: ein zweites Ausführungsbeispiel einer Energieführungskette mit einer pneumatischen Detektionsleitung, gezeigt in einem Längsschnitt;
- FIG.2b: eine Vergrößerung aus FIG.2a (Bereich R);
- FIG.2c: eine Vergrößerung aus FIG.2a (Bereich M);
- FIG.2d: eine perspektivische Ansicht eines Trennstegs der Energieführungskette nach FIG.2a;
- FIG.3a: ein weiteres Ausführungsbeispiel einer Energieführungskette, hier mit einer elektrischen Detektionsleitung, gezeigt in einem Längsschnitt;
- FIG.3b: eine Vergrößerung aus FIG.3a (Bereich E);
- FIG.3c: eine perspektivische Ansicht eines Trennstegs der Energieführungskette nach FIG.3a;
- FIG.3d: eine Frontansicht des Trennstegs nach FIG.3c;
- FIG.3e: einen Querschnitt des Trennstegs nach Schnittebene E-E aus FIG.3d;
- FIG.4: eine weiteres Ausführungsbeispiel einer Energieführungskette mit einer pneumatischen Detektionsleitung, hier in einer perspektivischen Ansicht; und
- FIG.5: eine schematische Darstellung eines erfindungsgemäßen Überwachungssystems.

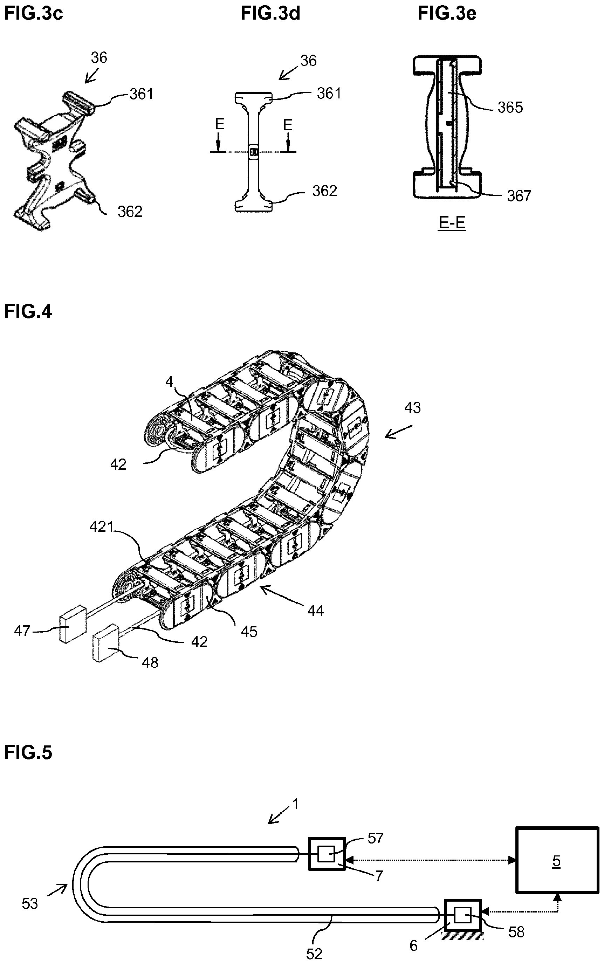

In FIG.5 ist beispielhaft ein Prinzipschema eines Überwachungssystems dargestellt, welches eine Energieführungskette 1 auf Fehlverhalten überwacht. Die Energieführungskette 1 führt und schützt Leitungen von einer meist stationären Basis 6 zu einem Mitnehmer 7, der sich relativ zur Basis 6 bewegt, z.B. linear vor und zurück. Die Energieführungskette 1 bildet dabei typisch einen Umlenkbogen 3 mit vorgegebenem Radius und hat einen vorbestimmten Sollverlauf, z.B. mit einem geraden Untertrum 2 einem gestreckt vorspannten, leicht nach unten durchhängenden, oder abgleitenden Obertrum 4 und dazwischen dem hin- und herfahrenden vorgegeben Umlenkbogen 3.

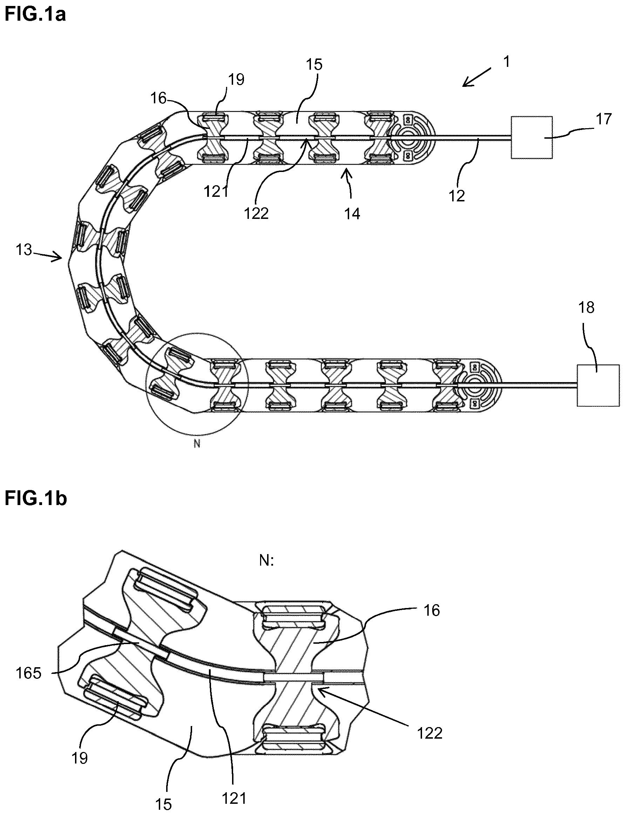

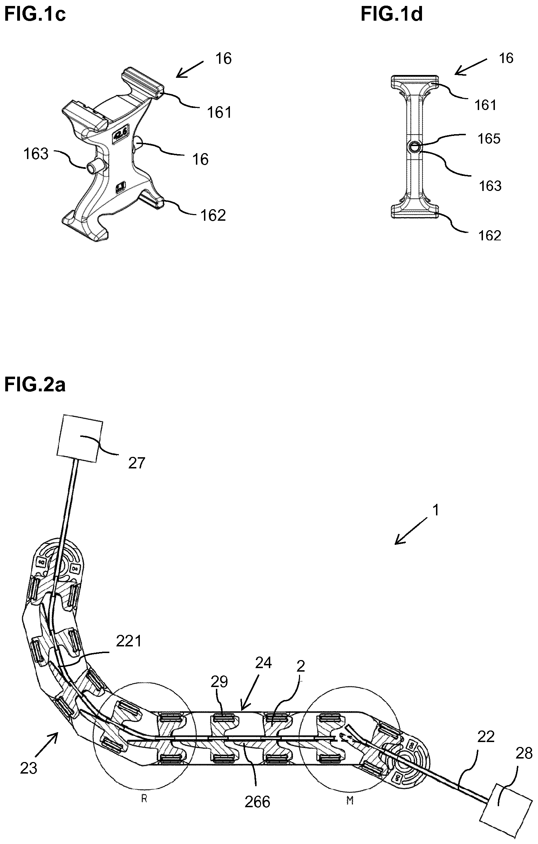

Eine Energieführungskette 1 ist z.B., wie in FIG.1a-1d gezeigt, aus einer Vielzahl in Längsrichtung verketteter Glieder 14 aufgebaut, die gegeneinander abwinkelbar sind. Die Glieder 14 haben Anschläge zur Einhaltung des Umlenkbogens 13 mit vordefiniertem Radius. Jedes Glied 14 umfasst zwei Seitenlaschen 15, von denen FIG.1a nur eine zeigt. Die beiden Seitenlaschen 15 eines Glieds 14 sind zueinander in Querrichtung, d.h. senkrecht zur Längsrichtung der Energieführungskette 1 bzw. der Ebene in Fig.1a, beabstandet und durch zwei Querstege 19 miteinander verbunden (vgl. Querstege 49 in FIG.4). Die Verkettung der Seitenlaschen 15 bildet je einen von zwei Laschensträngen, die entsprechend durch die Querstege 19 miteinander verbunden und parallel gehalten sind (vgl. FIG.4). Die Seitenlaschen 15 und die Querstege 19 bilden dazwischen einen Aufnahmeraum, in dem geführte Leitungen (nicht gezeigt) in das jeweilige Glied 14 aufgenommen sind. Benachbarte Laschen 15 in jedem Laschenstrang überlappen sich in Längsrichtung der Kette 1 und sind gegeneinander abwinkelbar. In FIG.1a ist als Bauweise eine Gliederkette mit Innen- und Außenlaschen gezeigt, bei welcher ein Glied 14 aus je vier Einzelteilen aufgebaut ist. Die Erfindung eignet sich jedoch für jegliche Bauart aktiver Leitungsführungen.

Wie FIG.1a-1d weiter zeigen, ist die Energieführungskette 1 mit einer eigenen (Engl.: dedicated) Spezialleitung, nämlich einer Detektionsleitung 12 ausgestattet. Die Detektionsleitung 12 besteht erfindungsgemäß aus einer Mehrzahl Leitungsabschnitten 121, die in Längsrichtung seriell miteinander verbunden sind. Im ersten Ausführungsbeispiel ist die Detektionsleitung 12 als pneumatischer Druckschlauch ausgeführt, der aus DruckschlauchAbschnitten 121 zusammengesetzt ist. Alle Druckschlauchabschnitte 121 sind identisch, insbesondere bzgl. Länge und vorbestimmtem Nenndurchmesser. Mit Druckluft als Detektionsmedium soll die Detektionsleitung 12 z.B. bestimmungsgemäß einen bestimmten Druck verlustfrei halten. Je zwei aufeinanderfolgende Druckschlauchabschnitte 121 sind lösbar durch geeignete Verbinder leitend miteinander verbunden. Jeder Verbinder ist in FIG.1a-1d als Kupplungsstück 122 bzw. in Art eines Schlauchverbinders bzw. einer Schlauchtülle ausgeführt, für eine hinreichend druckfeste Verbindung zweier Druckschlauchabschnitte 121. Wie in FIG.1b näher dargestellt, ist jedes Kupplungsstück 122 hier als integraler Bestandteil eines speziellen Trennstegs 16 ausgeführt und einstückig mit diesem hergestellt, z.B. aus Kunststoff im Spritzgussverfahren.

Jeder Trennsteg 16 kann in bekannter Art beidseitig an jeweils einem Quersteg 19 befestigt werden, z.B. form- und kraftschlüssig mittels Befestigungsklammern 161, 162, näher in FIG.1c zu sehen. Ein Trennsteg 16 erstreckt sich dabei quer zu den Querstegen 19 und zur der Längsrichtung der Kette 1 und teilt den Aufnahmeraum eines Glieds 14 auf bzw. ein. Jeder Trennsteg 16 bildet zwei axial gegenüberliegende Schlauchtüllen 163, 164 als Kernbestandteile des jeweiligen Verbinders 122. Die Schlauchtüllen 163, 164 sind mittig am Trennsteg 16 positioniert, sodass, wenn der Trennsteg 16 in die Energieführungskette 1 eingebaut ist, die Schlauchtüllen 163, 164 - und damit auch der Verbinder 122 - insgesamt sich auf der Höhe der neutralen Faser der Kette 1 befinden. Jede Schlauchtülle 163, 164 ist passend dimensioniert für eine lösbare Steck-Verbindung mit jeweils einem Druckschlauchabschnitt 121. Insbesondere die Durchmesser der Schlauchtüllen 163, 164 sind so auf den Durchmesser der Druckschlauchabschnitte 121 abgestimmt, dass die Druckschlauchabschnitte 121 auf die Schlauchtüllen 163, 164 von Hand aufgestülpt werden können und dabei eine leitende, hier druckdichte, Verbindung gewährleistet ist. Außerdem sind die Dimensionierung Schlauchtüllen 163, 164 und die Länge der Druckschlauchabschnitts 121 so gewählt, dass die Verbindung bei nicht bestimmungsgemäßer Beanspruchung gelöst wird, z.B. bei leichter Zugkraft durch übermäßige Biegung des

Druckschlauchabschnitts 121. Dadurch kann an einer kritischen Stelle die Verbindung der jeweiligen Schlauchtülle(n) 163, 164 mit dem Druckschlauchabschnitts 121 selbsttätig gelöst werden, wenn ein unerwünschtes Fehlverhalten der Energieführungskette 1 auftreten sollte, wie z.B. ein Bruch im Laschenstrang oder ein Aufbäumen des Obertrums 4. Es ist alternativ auch möglich, die Druckschlauchabschnitte 121 nicht auf die Schlauchtüllen 163, 164 aufzustülpen, sondern in diese einzustecken.

Die zwei Schlauchtüllen 163, 164 eines Trennstegs 16 sind durch einen Kanal für Druckluft 165 im Trennsteg 16 verbunden, der einen weiteren Bestandteil des Verbinders 122 in FIG.1a-1d bildet. Die Detektionsleitung 12 in dieser Ausführungsform besteht somit aus Druckschlauchabschnitten 121, Schlauchtüllen 163, 164 und Kanälen 165 in Trennstege 16. Sie liegt durch die Gestaltung der Trennstege 16 auf der Höhe der neutralen Faser der Energieführungskette 1 und ist in Richtung quer zu der Längsrichtung der Kette 1 gehalten. Hier erfüllen die Trennstege 16 also einerseits die Funktion von Haltern, welche die Detektionsleitung 12 auf der Höhe der neutralen Faser halten, und anderseits die Funktion der Verbinder 122, welche die Leitungsabschnitte 121 lösbar verbinden. Der Trennsteg 16, wie in FIG.1c dargestellt, ist als flacher Körper ausgeführt, dessen Stärke im mittleren Bereich allerdings ausreichend ist, um den Durchmesser des Kanals 165 aufzunehmen.

Jeder Druckschlauchabschnitt 121 ist somit jeweils endseitig an zwei benachbarten Gliedern 14 in Längsrichtung der Energieführungskette 1 durch die Trennstege 16 festgehalten. Ein Bruch in einem Glied 14, z.B. ein Bruch einer Seitenlasche 15, wird zur Änderung der Distanz zwischen Trennstegen 16 führen, die sich beidseitig der Bruchstelle befinden. Eine solche Änderung der Distanz wird zu einem Auftrennen bzw. Lösen mindestens einer der beiden Verbindungen zwischen dem Druckschlauchabschnitt 121 unmittelbar an der Bruchstelle, und einem der beiden angrenzenden Trennstege 16 führen. Dabei fällt der Druck zumindest kurzfristig ab, was leicht an einem Ende der Detektorleitung 12 messbar ist. Hierzu ist die Energieführungskette 1 mit einer Druckluftquelle 17 und mit einem Detektor 18 ausgerüstet, der als Drucksensor ausgeführt ist. Der Detektor 18 und die Druckluftquelle 17 sind an den gegenüberliegenden Enden der Detektorleitung 12 angeschlossen. Die Druckluftquelle 17 dient als Puffer und bewahrt langfristig einen vorgegebenen Druck in der Detektionsleitung 12. Der Drucksensor 18 kann feststellen, ob der Druck in der Detektionsleitung 12 kurzfristig abfällt infolge eines leitungsunterbrechenden Auftrennens der Detektionsleitung 12. Der Drucksensor 18 ist zu Automatisierungszwecken mit einer Auswerteeinheit 50 informationsübertragend verbunden, die ihrerseits z.B. mit der Steuerung des Mitnehmer 7 informationsübertragend verbunden ist, z.B. drahtlos per Funk. Die Auswerteeinheit 50 kann insbesondere einen Nothalt des Mitnehmers 7 der Energieführungskette 1 auslösen, sodass die Kette 1 nach einem Bruch repariert werden kann, bevor größerer Schaden insbesondere an den geführten Leitungen entsteht.

FIG.2a-2c zeigen ein zweites Ausführungsbeispiel der erfindungsgemäßen Überwachungsvorrichtung für eine Energieführungskette 1. Diese erlaubt es, zuverlässig auch einen nicht bestimmungsgemäßen Verlauf der Energieführungskette 1, insbesondere ein unerwünschtes Abwinkeln der Glieder 24 (gegen die Abwinkelungsrichtung des Umlenkbogens 23) zu detektieren.

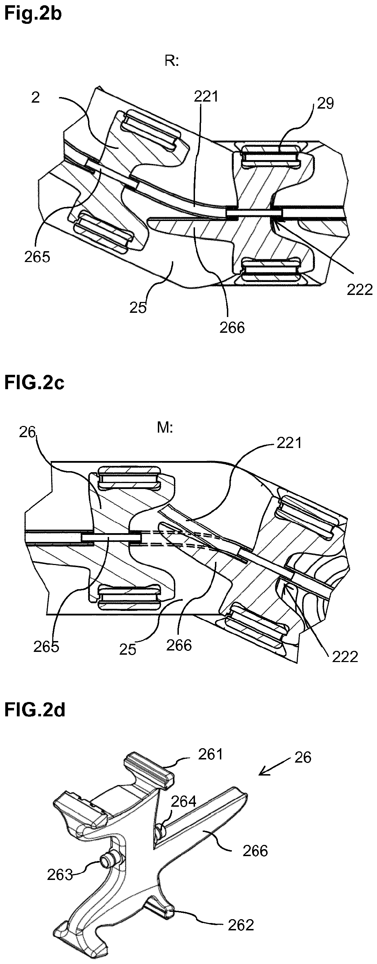

Die Variante in FIG.2a unterscheidet sich von der in FIG.1a vor allem durch eine Zusatzfunktion der Trennstege 26. Die Trennstege 26 bei dieser Ausführungsform weisen zusätzlich einen Hebelvorsprung 266 auf, der in Längsrichtung der Energieführungskette 1 vorsteht. Wenn benachbarte Glieder 24 infolge einer Störung gegeneinander über den vorbestimmten Winkelbereich hinaus in eine Richtung abwinkeln, die nicht der Soll- bzw. Vorwärts-Abwinkelungsrichtung der Glieder 24 im Umlenkbogen 23 entspricht, kommt der Hebelvorsprung 266 mit dem benachbarten Leitungsabschnitt 221 in Kontakt und trennt durch Hebelwirkung die Verbindung des entsprechenden Leitungsabschnitts 221 zum Verbinder 222 am benachbarten Trennsteg 26. Auch damit wird die Integrität der Detektionsleitung 22 unterbrochen, was der Detektor 28 detektieren kann. Die in FIG.2b detaillierter dargestellte Abwinkelungsrichtung der benachbarten Glieder 24 der gewünschten Abwinkelungsrichtung zur Bildung des Umlenkbogens 23, und der Hebelvorsprung 266 steht dieser nicht im Wege. In FIG.2c dagegen entspricht die Abwinkelungsrichtung der benachbarten Glieder 24 nicht der gewünschten Abwinkelungsrichtung. Der Hebelvorsprung 266 wirkt dann auf den Leitungsabschnitt 221, um die Verbindung des Leitungsabschnitts 221 zum Verbinder 222 am benachbarten Trennsteg 26 zu trennen. In FIG.2d ist der Trennsteg 26 als Einzelteil dargestellt, das wie in FIg.1c an sich bekannte Befestigungsklammern 261, 262 für den Quersteg 29, und erfindungsgemäß einen Verbinder 222 mit Schlauchtüllen 263, 264 und einem Druckluftkanal 265 aufweist.

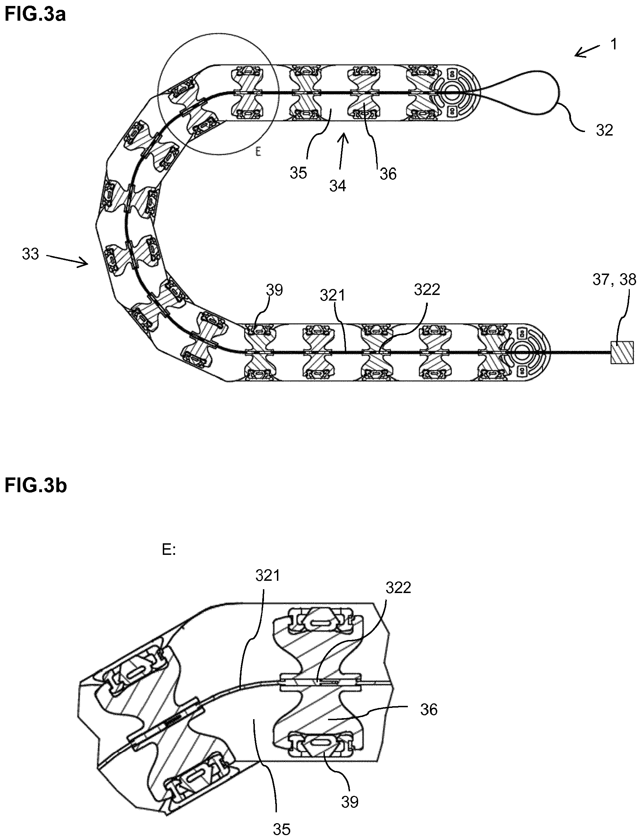

In FIG.3a ist ein alternatives Ausführungsbeispiel der erfindungsgemäßen Detektionsleitung 32 dargestellt, die nach einem elektrischen Funktionsprinzip arbeitet. Die Energieführungskette 1 ist analog zu FIG.1a aufgebaut, mit der Ausnahme der Bauweise der Detektionsleitung 32 und der als Halter für die Detektionsleitung 32 dienenden Trennstege. Die Detektionsleitung 32 umfasst bei der in FIG.3a dargestellten Ausführungsform eine Mehrzahl Leitungsabschnitte 321, die elektrische Leiter umfassen. Die elektrischen Leitungsabschnitte 321 sind durch elektrische Steckverbinder 322 leitend miteinander verbunden, um eine lösbare stromleitende Verbindung zweier Leitungsabschnitte 321 zu erlauben. Damit kann hier Strom oder Spannung als Detektionsmedium bzw. -signal genutzt werden. Es ist im Prinzip auch möglich, ein optisches Funktionsprinzip mit Lichtleitern zu verwenden.

Die lösbare Steckverbindung ist in FIG.3b detaillierter dargestellt. Jeder elektrischer Steckverbinder 322 ist an einem Trennsteg 36 auf der Höhe der neutralen Faser gehalten. Hierzu bildet der Trennsteg 36 eine Aufnahme 365, die passend zu den beiden zusammenwirkenden Steckerteilen (männlich/weiblich) der Steckverbinder 322 ausgebildet ist. Somit dient hier jeder der Trennstege 36, ohne Beitrag zur Verbindungsfunktion an sich, als Halter für die Steckverbinder 322 und damit auch zur Positionierung der zwei anliegenden Leitungsabschnitte 321. Wenn die Trennstege 36 eingebaut sind, befinden sich die Aufnahmen 365 für die Steckverbinder 322 ebenfalls auf der Höhe der neutralen Faser, sodass die Trennstege 36 die Detektionsleitung 32 auf der Höhe der neutralen Faser positionieren und halten. Die Steckverbinder 322 können in den Aufnahmen 365 in Längsrichtung der Energieführungskette lösbar arretiert sein, sodass ein Fehlverhalten der Kette 1 zwischen jeweils zwei Aufnahmen 365 zum leitungsunterbrechenden Auftrennen der Verbindung der zwei Leitungsabschnitte 321 führt. In FIG.3e ist eine Schnittebene E-E des Trennstegs 36 entlang der neutralen Faser dargestellt, in welcher eine Arretiervorrichtung 367 in der Aufnahme 365 zu sehen ist. Es ist auch eine Variante möglich, bei der die Trennstege 36 wie in den Figuren 2a-d aufweisen.

Die in FIG.3a dargestellte Detektionsleitung 32 ist endseitig mit einer Strom- bzw. Spannungsquelle 37 und mit einem Detektor 38 verbunden, der elektrische Spannung detektieren kann. Der Detektor 38 kann z.B. feststellen, wenn die Spannung in der Detektionsleitung 32 sprungartig verändert, was bestimmungsgemäß eintreten soll infolge eines leitungsunterbrechenden Auftrennens der Detektionsleitung 32. Der Detektor 38 ist mit einer Auswerteeinheit 50 signaltechnisch verbunden, die ihrerseits mit der Steuerung des Mitnehmers 7 verbunden ist.

Die in FIG.3a dargestellte elektrische Detektionsleitung 32 kann leichter als Schlaufe verlegt werden, d.h. sie ist von einem Ende der Energieführungskette 1 ausgehend zu diesem zurückgeführt. Eine Schlaufe muss sich dabei nicht über die gesamte Energieführungskette 1 erstrecken. Jeder Steckverbinder 32 ist als Verbinder für ein Leiterpaar aus zwei elektrischen Leitern ausgeführt. In FIG.3a sind die Quelle 37 und der Detektor 38 als Funktionseinheit an demselben Ende der Energieführungskette 1 angeordnet.

In FIG.4 ist ein Ausführungsbeispiel der Energieführungskette 1 dargestellt, bei der die Detektionsleitung 42 als Druckluftleitung ausgeführt ist, die eine Schlaufe entlang der Energieführungskette 1 bildet. Die Druckluftquelle 47 und der Detektor 48 sind beide an ein und demselben Ende der Energieführungskette 1 angeordnet. Die Detektionsleitung 42 in FIG.4 ist an den Innenseiten der Laschenstränge angrenzend, seitlich außen im Aufnahmeraum der Energieführungskette 1, um einen Bruch in jedem Laschenstrang besser erkennen zu können. Die Detektionsleitung 42 erstreckt sich entlang eines Laschenstrangs ausgehend von der Quelle 47 an der Basis 6 der Kette 1 zum anderen Ende der Kette 1 und wieder zurück entlang des anderen Laschenstrangs. Die Halter für die Detektionsleitung 42 sind an den Seitenlaschen 45 angeordnet, sodass in dem mittleren Bereich des Querschnitts der Energieführungskette 1 mehr Platz für Leitungen wie Schläuche und Kabel verbleit.

In FIG.5 zeigt, wie eingangs erwähnt, ein allgemeines Prinzipschema des erfindungsgemäßen Überwachungssystems für eine Energieführungskette 1. Das Überwachungssystem umfasst eine Detektionsleitung 52, die durch Halter auf der Höhe der neutralen Faser gehalten wird, eine Quelle 57 die ein Detektionsmedium in die Detektionsleitung 52 einspeisen kann und einen Detektor 58, der das Detektionsmedium in der Detektionsleitung 52 hinsichtlich einer Zustandsänderung überwacht. Eine Auswerteeinheit 50 ist mit dem Detektor 58 informationsübertragend verbunden, um Maßnahmen zum Schutz der Energieführungskette 1 und der darin geführten Leitungen auszulösen, wenn ein unerwünschtes Verhalten durch die Detektionsleitung 52 angezeigt wird.

### Bezugszeichenliste

**FIG.1**
   - 12: Detektionsleitung
   - 121: Leitungsabschnitt
   - 122: Kupplungsstück
   - 13: Umlenkbogen
   - 14: Glied der Energieführungskette
   - 15: Seitenlasche
   - 16: Trennsteg
   - 161; 162: Befestigungsklammern
   - 163; 164: Schlauchtüllen
   - 165: Kanal im Trennsteg
   - 17: Quelle
   - 18: Detektor
   - 19: Quersteg
**FIG. 2**
   - 22: Detektionsleitung
   - 221: Leitungsabschnitt
   - 222: Kupplungsstück
   - 23: Umlenkbogen
   - 24: Glied der Energieführungskette
   - 25: Seitenlasche
   - 26: Trennsteg
   - 261; 262: Befestigungsklammern
   - 263: Schlauchtüllen
   - 265: Kanal im Trennsteg
   - 266: Hebelvorsprung
   - 27: Quelle
   - 28: Detektor
   - 29: Quersteg
**FIG. 3**
   - 32: Detektionsleitung
   - 321: Leitungsabschnitt
   - 322: Steckverbinder
   - 33: Umlenkbogen
   - 34: Glied der Energieführungskette
   - 35: Seitenlasche
   - 36: Trennsteg
   - 361; 362: Befestigungsklammern
   - 365: Aufnahme im Trennsteg
   - 367: Arretiervorrichtung
   - 37: Quelle
   - 38: Detektor
   - 39: Quersteg
**FIG. 4**
   - 42: Detektionsleitung
   - 421: Leitungsabschnitt
   - 43;: Umlenkbogen
   - 44: Glied der Energieführungskette
   - 45: Seitenlasche
   - 47: Quelle
   - 48: Detektor
   - 49: Quersteg
**FIG. 5**
   - 1: Energieführungskette
   - 2: Untertrum
   - 3: Umlenkbogen
   - 4: Obertrum
   - 6: Basis (Festpunkt)
   - 7: Mitnehmer
   - 50: Auswerteeinheit

## Patentansprüche

1. Energieführungskette (1), umfassend eine Vielzahl miteinander verbundener Glieder bzw. Segmente (14; 24; 34; 44) zur Führung einer oder mehrerer Leitungen, wie Kabel, Schläuche oder dergleichen, zwischen einer Basis (6) an einem Ende der Energieführungskette (1) und einem relativ zur Basis beweglichen Mitnehmer (7) am anderen Ende der Energieführungskette (1), wobei die Glieder bzw. Segmente (14; 24; 34; 44) zur Bildung eines Umlenkbogens (13; 23; 33; 43; 3) gegeneinander abwinkelbar sind, wobei die Energieführungskette (1) mit einer Detektionsleitung (12; 22; 32; 42; 52) zum Erfassen eines Fehlverhaltens der Energieführungskette (1) ausgestattet ist, die auf Höhe der neutralen Faser der Energieführungskette (1) angeordnet ist, **dadurch gekennzeichnet, dass** die Detektionsleitung (12; 22; 32; 42; 52) zumindest über eine Teillänge der Energieführungskette (1), insbesondere über eine Länge entsprechend dem Bewegungsbereich des Umlenkbogens (13; 23; 33; 43; 3), aus einer Mehrzahl einzelner Leitungsabschnitte (121; 221; 321; 421) zusammengesetzt ist, welche durch lösbare Verbindungen leitend miteinander verbunden sind, sodass ein Fehlverhalten der Energieführungskette (1) zum leitungsunterbrechenden Auftrennen mindestens einer der Verbindungen führt und die resultierende Leitungsunterbrechung mit einem Detektor (18; 28; 38; 48; 58) erfassbar ist.

2. Energieführungskette (1) nach Anspruch 1, wobei die lösbaren Verbindungen, durch welche die Leitungsabschnitte (121; 221; 321; 421) miteinander verbunden sind, als Steckverbindungen ausgeführt sind, insbesondere in Leitungslängsrichtung steckbare Steckverbindungen.

3. Energieführungskette (1) nach Anspruch 1 oder 2, wobei zu jeder lösbaren Verbindung zwischen zwei aufeinanderfolgenden Leitungsabschnitten (121; 221; 321; 421) jeweils mindestens ein Verbinder vorgesehen ist, welcher vorzugsweise durch einen Halter an einem Glied bzw. Segment (14; 24; 34; 44) gehalten ist.

4. Energieführungskette (1) nach einem der Ansprüche 1, 2 oder 3, wobei über eine Teillänge der Energieführungskette (1), zumindest an jedem zweiten Glied bzw. Segment (14; 24; 34; 44), vorzugsweise an jedem Glied bzw. Segment (14; 24; 34; 44), jeweils eine lösbare Verbindung zum leitenden Verbinden von zwei Leitungsabschnitten (121; 221; 321; 421) gehalten ist.

5. Energieführungskette (1) nach Anspruch 3 oder 4, wobei der Verbinder durch den Halter an dem Glied bzw. Segment (14; 24; 34; 44) auf Höhe der neutralen Faser der Energieführungskette (1) mechanisch gehalten und in Längsrichtung der Energieführungskette (1) arretiert bzw. festgelegt ist.

6. Energieführungskette (1) nach einem der vorangehenden Ansprüche, wobei jeder Leitungsabschnitt als Druckschlauchabschnitt (121; 221) für ein Druckmedium, insbesondere als pneumatischer Schlauchabschnitt für Druckluft, ausgebildet ist, und jeder Verbinder als Kupplungsstück (122; 222) ausgebildet ist, das einen Kanal (165; 265) für das Druckmedium aufweist und beidseitig in Längsrichtung der Energieführungskette (1) mit zwei Schlauchtüllen (163, 164; 263, 264) ausgestattet ist, die jeweils eine lösbare Verbindung mit einem Druckschlauchabschnitt (121; 221) erlauben, vorzugsweise wobei jeder Druckschlauchabschnitt (121; 221) als pneumatischer Druckschlauchabschnitt ausgebildet ist und jedes Kupplungsstück (122; 222) durch einen Halter, insbesondere in Form eines Trennstegs (16; 26), gehalten wird.

7. Energieführungskette (1) nach einem der Ansprüche 1 bis 5, wobei jeder Leitungsabschnitt (321) einen elektrischen Leiter umfasst und die lösbaren Verbindungen jeweils durch elektrische Steckverbinder (322) gebildet sind, vorzugsweise wobei jeder Steckverbinder (322) durch jeweils einen Halter, insbesondere in Form eines Trennstegs (36), auf der Höhe der neutralen Faser gehalten wird, und der Halter eine Aufnahme (365) aufweist, die passend zu dem Steckverbinder (322) ausgebildet ist; wobei vorzugsweise jeweils benachbarten Leitungsabschnitte in etwa gleiche Leitfähigkeit aufweisen.

8. Energieführungskette (1) nach einem der Ansprüche 1 bis7, wobei die Zugfestigkeit der lösbaren Verbindung jeweils zweier Leitungsabschnitte geringer ist, als die Zugfestigkeit dieser Leitungsabschnitte, und/oder die lösbaren Verbindungen zerstörungsfrei lösbar sind, und/oder die Verbindungen bei einer vordefinierten Kraft lösbar sind.

9. Energieführungskette (1) nach einem der Ansprüche 3 bis8, wobei zumindest einige der Halter jeweils einen in Längsrichtung der Energieführungskette (1) vorstehenden Hebelvorsprung (266) aufweisen, wobei der Hebelvorsprung (266) so ausgebildet ist, dass dieser bei einem unerwünschten Abwinkeln der Glieder bzw. Segmente (24) mit einem Leitungsabschnitt (221) zusammenwirkt, um dessen Verbindung zum nächsten Leitungsabschnitt (221) zu trennen.

10. Energieführungskette (1) nach einem der vorangehenden Ansprüche, wobei mindestens einige der Leitungsabschnitte (121; 221; 321; 421) der Detektionsleitung (12; 22; 32; 42), vorzugsweise jeder Leitungsabschnitt (121; 221; 321; 421), jeweils endseitig an einem von zwei benachbarten Gliedern bzw. Segmenten (14; 24; 34; 44) der Energieführungskette (1) lösbar befestigt ist.

11. Energieführungskette (1) nach einem der vorangehenden Ansprüche, wobei die Detektionsleitung (32; 42) eine Schlaufe entlang zumindest einer Teillänge der Energieführungskette (1) bildet und von einem Ende der Energieführungskette (1) ausgehend zu diesem Ende zurückgeführt ist.

12. Energieführungskette (1) nach einem der vorangehenden Ansprüche, insbesondere nach Anspruch11, wobei die Energieführungskette (1) Glieder (44) mit einem Aufnahmeraum zur Aufnahme der geführten Leitungen umfasst, der durch jeweils mindestens eine Seitenlasche (45), insbesondere durch zwei parallel gegenüberliegende Seitenlaschen, begrenzt ist, wobei die Seitenlaschen (45) in Längsrichtung der Energieführungskette (1) schwenkbar miteinander verbunden sind und mindestens einen Laschenstrang bilden, wobei die Detektionsleitung (42), insbesondere die Schlaufe, in dem Aufnahmeraum, vorzugsweise seitlich außen zum Aufnahmeraum an dem Laschenstrang, angeordnet ist,
insbesondere wobei die Seitenlaschen durch Aufnahme-Bolzen Verbindung in Längsrichtung der Energieführungskette (1) schwenkbar miteinander verbunden sind.

13. Bausatz zum Nachrüsten einer Energieführungskette (1) mit einer Detektionsleitung (12; 22; 32; 42) zum Erfassen eines Fehlverhaltens der Energieführungskette (1), umfassend
- eine Mehrzahl einzelner Leitungsabschnitte (121; 221; 321; 421), welche durch lösbare Verbindungen zu einer Detektionsleitung (12; 22; 32; 42) leitend miteinander verbindbar sind, sodass ein Fehlverhalten der Energieführungskette (1) zum leitungsunterbrechenden Auftrennen mindestens einer der Verbindungen führen kann und die resultierende Leitungsunterbrechung mit einem Detektor (18; 28; 38; 48) erfassbar sein kann;
- Verbinder zum Herstellen der lösbaren Verbindungen zwischen den Leitungsabschnitten (121; 221; 321; 421);und
- Halter zum Anordnen der Detektionsleitung (12; 22; 32; 42) auf Höhe der neutralen Faser der Energieführungskette (1) zumindest über eine Teillänge der Energieführungskette (1), insbesondere über eine Länge entsprechend dem Bewegungsbereich des Umlenkbogens (3; 13; 23; 33; 43), vorzugsweise wobei die Halter als Trennstege (16; 26; 36) ausgebildet sind, die an Gliedern bzw. Segmenten (14; 24; 34) der Energieführungskette (1) angebracht werden können.

14. Überwachungssystem für eine Energieführungskette (1), umfassend
- eine Detektionsleitung (12; 22; 32; 42; 52) zum Erfassen eines Fehlverhaltens der Energieführungskette (1), wobei die Detektionsleitung (12; 22; 32; 42; 52) aus einer Mehrzahl einzelner Leitungsabschnitte (121; 221; 321; 421) zusammengesetzt ist, welche durch lösbare Verbindungen leitend miteinander verbunden sind, sodass bestimmungsgemäß ein Fehlverhalten der Energieführungskette (1) zum leitungsunterbrechenden Auftrennen mindestens einer der Verbindungen führen kann und die resultierende Leitungsunterbrechung mit einem Detektor (18; 28; 38; 48; 58) erfassbar sein kann, vorzugsweise wobei die lösbaren Verbindungen, durch welche die einzelnen Leitungsabschnitte (121; 221; 321; 421) miteinander verbunden sind, als Steckverbindungen ausgeführt sind, die insbesondere bei einer vordefinierten Kraft lösbar sind;
- Halter zum Anordnen der Detektionsleitung (12; 22; 32; 42; 52) auf Höhe der neutralen Faser der Energieführungskette (1) zumindest über eine Teillänge der Energieführungskette (1), insbesondere über eine Länge entsprechend dem Bewegungsbereich des Umlenkbogens (13; 23; 33; 43; 3);
- eine Quelle (17; 27; 37; 47; 57) für ein Detektionsmedium, welches die Detektionsleitung (12; 22; 32; 42; 52) leiten kann, wobei die Quelle mit der Detektionsleitung (12; 22; 32; 42; 52) verbunden ist und das Detektionsmedium in die Detektionsleitung (12; 22; 32; 42; 52) einspeisen kann;
- einen Detektor (18; 28; 38; 48; 58), der mit der Detektionsleitung (12; 22; 32; 42; 52) verbindbar ist und eine Leitungsunterbrechung detektieren kann; und
- eine Auswerteeinheit (50), die mit dem Detektor informationsübertragend verbindbar ist.

15. Überwachungssystem nach Anspruch 14, wobei die Quelle eingerichtet ist um Druckluft in die Detektionsleitung (12; 22; 42) einzuspeisen und der Detektor (18; 28; 48) als Drucksensor ausgebildet ist; oder wobei die Quelle eingerichtet ist um elektrische Spannung an die Detektionsleitung (32) anzulegen und der Detektor (38) eingerichtet ist um diese Spannung zu überwachen.

16. Überwachungssystem nach einem der Ansprüche 14 oder 15, wobei die Auswerteeinheit (50) ein Fehlverhalten der Energieführungskette (1) erkennt, wenn der Detektor (58) eine Unterbrechung der Detektionsleitung (52) detektiert, um eine Schutzmaßnahme auszulösen.

17. Überwachungssystem nach einem der Ansprüche 14 bis 16, wobei die Halter als separate mit den Gliedern bzw. Segmenten (14; 24; 34) der Energieführungskette (1) verbindbare Bauteile, insbesondere als Trennstege (16; 26; 36), ausgebildet sind.

## Claims

1. An energy guide chain (1) comprising a plurality of links or segments (14; 24; 34; 44) which are connected to one another for guiding one or more lines, such as cables, hoses or the like, between a base (6) at one end of the energy guide chain (1) and, at the other end of the energy supply chain (1), a moving end (7) which is mobile relative to the base, wherein the links or segments (14; 24; 34; 44) are pivotable relative to one another to form a deflection arc (13; 23; 33; 43; 3), wherein the energy guide chain (1) is equipped with a detection line (12; 22; 32; 42; 52) for detecting a malfunction of the energy guide chain (1) which is arranged at the neutral axis height of the energy guide chain (1), **characterized in that** the detection line (12; 22; 32; 42; 52) is composed at least over a part of the length of the energy guide chain (1), in particular over a length corresponding to the movement range of the deflection arc (13; 23; 33; 43; 3), of a plurality of individual line portions (121; 221; 321; 421) which are conductively connected to one another by disconnectable connections, such that a malfunction of the energy guide chain (1) leads to at least one of the connections being undone in conduction-interrupting manner and the resultant interruption in conduction is detectable with a detector (18; 28; 38; 48; 58).

2. The energy guide chain (1) as claimed in claim 1, wherein the disconnectable connections which connect the line portions (121; 221; 321; 421) to one another are embodied as plug-in connections, in particular as plug-in connections which can be plugged together in the longitudinal direction of the line.

3. The energy guide chain (1) as claimed in claim 1 or 2, wherein at least one connector, which is preferably held by a holder on a link or segment (14; 24; 34; 44), is provided for each disconnectable connection between two successive line portions (121; 221; 321; 421).

4. The energy guide chain (1) as claimed in one of claims 1, 2 or 3, wherein a disconnectable connection for conductively connecting two line portions (121; 221; 321; 421) is held over a part of the length of the energy guide chain (1), at least on every second link or segment (14; 24; 34; 44), preferably on each link or segment (14; 24; 34; 44),

5. The energy guide chain (1) as claimed in claim 3 or 4, wherein the connector is mechanically held at the neutral axis height of the energy guide chain (1) by the holder on the link or segment (14; 24; 34; 44) and is locked or fixed in the longitudinal direction of the energy guide chain (1).

6. The energy guide chain (1) as claimed in one of the preceding claims, wherein each line portion is embodied as a pressure hose portion (121; 221) for a pressure medium, in particular as a pneumatic hose portion for compressed air, and each connector is embodied as a coupling piece (122; 222) which has a duct (165; 265) for the pressure medium and is equipped on both sides in the longitudinal direction of the energy guide chain (1) with two hose nozzles (163, 164; 263, 264), each of which permits a disconnectable connection with a pressure hose portion (121; 221),wherein preferably each pressure hose portion (121; 221) is embodied as a pneumatic pressure hose portion and each coupling piece (122; 222) is held by a holder, in particular in the form of a separating web (16; 26).

7. The energy guide chain (1) as claimed in one of claims 1 to 5, wherein each line portion (321) comprises an electrical conductor and the disconnectable connections are in each case formed by electrical plug-in connectors (322),wherein preferably each plug-in connector (322) is held at neutral axis height, by a holder, in particular in the form of a separating web (36), wherein the holder has a socket (365) which is embodied to fit the plug-in connector (322); wherein preferably in each case adjacent line portions have approximately identical conductivity.

8. The energy guide chain (1) as claimed in one of claims 1 to 7, wherein the tensile strength of the disconnectable connection between two line portions is lower than the tensile strength of these line portions, and/or the disconnectable connections are non-destructively disconnectable and/or the connections are disconnectable at a predefined force.

9. The energy guide chain (1) as claimed in one of claims 3 to 8, wherein at least some of the holders each have a lever projection (266) protruding in the longitudinal direction of the energy guide chain (1), wherein the lever projection (266) is embodied such that, in the event of undesired pivoting of the links or segments (24), it interacts with a line portion (221) in order to undo the connection thereof to the next line portion (221) .

10. The energy guide chain (1) as claimed in one of the preceding claims, wherein at least some of the line portions (121; 221; 321; 421) of the detection line (12; 22; 32; 42), preferably each line portion (121; 221; 321; 421), is disconnectably fastened at the end to one of two adjacent links or segments (14; 24; 34; 44) of the energy guide chain (1).

11. The energy guide chain (1) as claimed in one of the preceding claims, wherein the detection line (32; 42) forms a loop along at least one part of the length of the energy guide chain (1), starting from one end of the energy guide chain (1) and returning to said end.

12. The energy guide chain (1) as claimed in one of the preceding claims, in particular as claimed in claim 11, wherein the energy guide chain (1) comprises links (44) with an accommodation space for accommodating the guided lines which is in each case bounded by at least one side plate (45), in particular by two opposing parallel side plates, wherein the side plates (45) are swivelably connected to one another in the longitudinal direction of the energy guide chain (1) and form at least one string of plates, wherein the detection line (42), in particular the loop, is arranged in the accommodation space, preferably laterally externally to the accommodation space on the string of plates, in particular wherein the side plates are swivelably connected to one another by socket-and-pin connection in the longitudinal direction of the energy guide chain (1).

13. A kit for retrofitting an energy guide chain (1) with a detection line (12; 22; 32; 42) for detecting a malfunction of the energy guide chain (1) comprising
- a plurality of individual line portions (121; 221; 321; 421) which are conductively connectable to one another by disconnectable connections to form a detection line (12; 22; 32; 42), such that a malfunction of the energy guide chain (1) may lead to at least one of the connections being undone in conduction-interrupting manner and the resultant interruption in conduction may be detectable with a detector (18; 28; 38; 48);
- connectors for creating the disconnectable connections between the line portions (121; 221; 321; 421); and
- holders for arranging the detection line (12; 22; 32; 42) at the neutral axis height of the energy guide chain (1) over at least part of the length of the energy guide chain (1), in particular over a length corresponding to the movement range of the deflection arc (3; 13; 23; 33; 43), wherein preferably the holders are embodied as separating webs (16; 26; 36) which can be mounted on links or segments (14; 24; 34) of the energy guide chain (1).

14. An energy guide chain monitoring system (1) comprising
- a detection line (12; 22; 32; 42; 52) for detecting a malfunction of the energy guide chain (1), wherein the detection line (12; 22; 32; 42; 52) is composed of a plurality of individual line portions (121; 221; 321; 421) which are conductively connected to one another by disconnectable connections, such that in intended manner a malfunction of the energy guide chain (1) may lead to at least one of the connections being undone in conduction-interrupting manner and the resultant interruption in conduction possibly being detectable with a detector (18; 28; 38; 48; 58), wherein preferably the disconnectable connections which connect the individual line portions (121; 221; 321; 421) to one another are embodied as plug-in connections which are in particular disconnectable at a predefined force;
- holders for arranging the detection line (12; 22; 32; 42; 52) at the neutral axis height of the energy guide chain (1) over at least part of the length of the energy guide chain (1), in particular over a length corresponding to the movement range of the deflection arc (13; 23; 33; 43; 3);
- a source (17; 27; 37; 47; 57) for a detection medium which the detection line (12; 22; 32; 42; 52) can conduct, wherein the source is connected to the detection line (12; 22; 32; 42; 52) and can feed the detection medium into the detection line (12; 22; 32; 42; 52);
- a detector (18; 28; 38; 48; 58) which is connectable to the detection line (12; 22; 32; 42; 52) and can detect an interruption in conduction; and
- an evaluation unit (50) which is connectable for data transfer to the detector.

15. The monitoring system as claimed in claim 14, wherein the source is configured to feed compressed air into the detection line (12; 22; 42) and the detector (18; 28; 48) is embodied as a pressure sensor; or wherein the source is configured to apply an electrical voltage to the detection line (32) and the detector (38) is configured to monitor this voltage.

16. The monitoring system as claimed in either of claims 14 or 15, wherein the evaluation unit (50) detects a malfunction of the energy guide chain (1) when the detector (58) detects an interruption of the detection line (52) in order to trigger a protective measure.

17. The monitoring system as claimed in one of claims 14 to 16, wherein the holders are embodied as separate components, in particular as separating webs (16; 26; 36), which are connectable to the links or segments (14; 24; 34) of the energy guide chain (1).

## Revendications

1. Chaîne porte-câbles (1), comprenant une pluralité de maillons ou segments (14; 24; 34; 44) reliés entre eux pour le guidage d'une ou de plusieurs lignes, telles que des câbles, des tuyaux ou similaires, entre une base (6) à une extrémité de la chaîne porte-câbles (1) et un entraîneur (7) mobile par rapport à la base à l'autre extrémité de la chaîne porte-câbles (1), les maillons ou segments (14; 24; 34; 44) peuvant être coudés l'un par rapport à l'autre pour former un arc de renvoi (13; 23; 33; 43; 3), la chaîne porte-câbles (1) étant équipée d'une ligne de détection (12; 22; 32; 42; 52) pour détecter un comportement erroné de la chaîne porte-câbles (1), qui est disposée au niveau de la fibre neutre de la chaîne porte-câbles (1), **caractérisé en ce que** la ligne de détection (12; 22; 32; 42; 52) est composée, au moins sur une longueur partielle de la chaîne porte-câbles (1), en particulier sur une longueur correspondant à la zone de déplacement de l'arc de renvoi (13; 23; 33; 43; 3), d'une pluralité de tronçons de ligne individuels (121; 221; 321; 421) qui sont reliés entre eux de manière conductrice par des liaisons détachables, de sorte qu'un comportement erroné de la chaîne porte-câbles (1) provoque une rupture, avec interruption de la ligne, d'au moins l'une des liaisons et que l'interruption de ligne qui en résulte peut être détectée par un détecteur (18; 28; 38; 48; 58).

2. Chaîne porte-câbles (1) selon la revendication 1, dans laquelle les liaisons amovibles, par lesquelles les tronçons de ligne (121; 221; 321; 421) sont reliés entre eux, sont réalisées sous forme de liaisons enfichables, en particulier des liaisons enfichables dans la direction longitudinale de la ligne.

3. Chaîne porte-câbles (1) selon la revendication 1 ou 2, dans laquelle, pour chaque liaison amovible entre deux tronçons de ligne successifs (121; 221; 321; 421), il est prévu respectivement au moins un connecteur qui est maintenu de préférence par un support sur un élément ou segment (14; 24; 34; 44) .

4. Chaîne porte-câbles (1) selon l'une des revendications 1, 2 ou 3, dans laquelle, sur une longueur partielle de la chaîne porte-câbles (1), au moins sur chaque deuxième maillon ou segment (14; 24; 34; 44), de préférence sur chaque maillon ou segment (14; 24; 34; 44), est maintenue à chaque fois une liaison amovible pour relier de manière conductrice deux tronçons de ligne (121; 221; 321; 421).

5. Chaîne porte-câbles (1) selon la revendication 3 ou 4, dans laquelle le connecteur est maintenu mécaniquement par le support sur le maillon ou segment (14; 24; 34; 44) au niveau de la fibre neutre de la chaîne porte-câbles (1) et est bloqué ou fixé dans la direction longitudinale de la chaîne porte-câbles (1).

6. Chaîne porte-câbles (1) selon l'une des revendications précédentes, dans laquelle chaque tronçon de ligne est réalisé sous forme de tronçon de tuyau flexible de pression (121; 221) pour un fluide sous pression, en particulier sous forme de tronçon de tuyau flexible pneumatique pour de l'air comprimé, et chaque connecteur est réalisé sous forme de pièce d'accouplement (122; 222) qui présente un canal (165; 265) pour le fluide sous pression et qui est équipée des deux côtés dans le sens longitudinal de la chaîne porte-câbles (1) de deux douilles de tuyau flexible (163, 164; 263, 264) qui permettent chacune une liaison amovible avec un tronçon de tuyau de pression (121; 221), de préférence chaque tronçon de tuyau de pression (121; 221) étant conçu comme un tronçon de tuyau de pression pneumatique et chaque pièce d'accouplement (122; 222) étant maintenue par un support, en particulier sous la forme d'une traverse de séparation (16; 26).

7. Chaîne porte-câbles (1) selon l'une des revendications 1 à 5, dans laquelle chaque tronçon de ligne (321) comprend un conducteur électrique et les liaisons amovibles sont formées respectivement par des connecteurs électriques enfichables (322), de préférence dans laquelle chaque connecteur enfichable (322) est maintenu au niveau de la fibre neutre par un support respectif, notamment sous la forme d'une traverse de séparation (36), et le support présente un logement (365) qui est réalisé de manière à s'adapter au connecteur enfichable (322); dans laquelle de préférence des tronçons de ligne respectivement voisins présentent approximativement la même conductivité.

8. Chaîne porte-câbles (1) selon l'une des revendications 1 à 7, dans laquelle la résistance à la traction de la liaison amovible de deux tronçons de ligne respectifs est inférieure à la résistance à la traction de ces tronçons de ligne, et/ou les liaisons amovibles peuvent être détachées sans destruction, et/ou les liaisons peuvent être détachées avec une force prédéfinie.

9. Chaîne porte-câbles (1) selon l'une des revendications 3 à 8, dans laquelle au moins certains des supports présentent chacun une saillie de levier (266) faisant saillie dans la direction longitudinale de la chaîne porte-câbles (1), la saillie de levier (266) étant conçue de telle sorte que, en cas de pliage indésirable des maillons ou segments (24), elle coopère avec un tronçon de ligne (221) pour couper sa liaison avec le tronçon de ligne suivante (221).

10. Chaîne porte-câbles (1) selon l'une des revendications précédentes, dans laquelle au moins certains des tronçons de ligne (121; 221; 321; 421) de la ligne de détection (12; 22; 32; 42), de préférence chaque tronçon de ligne (121; 221; 321; 421), est fixé de manière amovible, à chaque extrémité, à l'un de deux maillons ou segments voisins (14; 24; 34; 44) de la chaîne porte-câbles (1).

11. Chaîne porte-câbles (1) selon l'une des revendications précédentes, dans laquelle la ligne de détection (32; 42) forme une boucle le long d'au moins une longueur partielle de la chaîne porte-câbles (1) et est ramenée vers cette extrémité en partant d'une extrémité de la chaîne porte-câbles (1).

12. Chaîne porte-câbles (1) selon l'une des revendications précédentes, en particulier selon la revendication 11, dans laquelle la chaîne porte-câbles (1) comprend des maillons (44) avec un espace de réception pour recevoir les câbles guidés, espace qui est délimité par au moins une patte latérale (45), en particulier par deux pattes latérales parallèles opposées, les pattes latérales (45) étant reliées entre elles de manière pivotante dans le sens longitudinal de la chaîne porte-câble (1) et formant au moins un cordon de pattes, la ligne de détection (42), en particulier la boucle, étant disposée dans l'espace de réception, de préférence latéralement à l'extérieur de l'espace de réception sur le cordon de pattes,
en particulier les pattes latérales étant reliées entre elles de manière pivotante dans le sens longitudinal de la chaîne porte-câbles par une liaison réception-boulon.

13. Kit pour équiper ultérieurement une chaîne porte-câbles (1) d'une ligne de détection (12; 22; 32; 42) pour détecter un comportement erroné de la chaîne porte-câbles (1), comprenant
- une pluralité de tronçons de ligne individuels (121; 221; 321; 421) qui peuvent être reliées entre eux de manière conductrice par des liaisons amovibles pour former une ligne de détection (12; 22; 32; 42), de sorte qu'un comportement erroné de la chaîne porte-câbles (1) peut conduire à la rupture, avec interruption de la ligne, d'au moins l'une des liaisons et que l'interruption de ligne qui en résulte peut être détectée par un détecteur (18; 28; 38; 48);
- des connecteurs pour réaliser les liaisons amovibles entre les tronçons de ligne (121; 221; 321; 421); et
- des supports pour disposer la ligne de détection (12; 22; 32; 42) au niveau de la fibre neutre de la chaîne porte-câbles (1) au moins sur une longueur partielle de la chaîne porte-câbles (1), en particulier sur une longueur correspondant à la zone de déplacement de l'arc de renvoi (3; 13; 23; 33; 43), de préférence les supports étant conçus comme des séparateurs (16; 26; 36) qui peuvent être montés sur des maillons ou des segments (14; 24; 34) de la chaîne porte-câble (1).

14. Système de surveillance pour une chaîne porte-câbles (1) comprenant
- une ligne de détection (12; 22; 32; 42; 52) pour détecter un comportement erroné de la chaîne porte-câbles (1), la ligne de détection (12; 22; 32; 42; 52) étant composée d'une pluralité de tronçons de ligne individuels (121; 221; 321; 421) qui sont reliées entre eux de manière conductrice par des liaisons amovibles, de sorte que, conformément aux dispositions, un comportement erroné de la chaîne porte-câbles (1) peut conduire à la rupture interrompant la ligne d'au moins l'une des liaisons et que l'interruption de ligne résultante peut être détectée par un détecteur (18; 28; 38; 48; 58), de préférence les liaisons amovibles par lesquelles les différents tronçons de ligne (121; 221; 321; 421) sont reliés entre eux étant réalisées sous forme de liaisons par enfichage qui peuvent être détachées en particulier sous une force prédéfinie;
- des supports pour disposer la ligne de détection (12; 22; 32; 42; 52) au niveau de la fibre neutre de la chaîne porte-câbles (1) au moins sur une longueur partielle de la chaîne porte-câbles (1), en particulier sur une longueur correspondant à la zone de déplacement de l'arc de renvoi (13; 23; 33; 43; 3);
- une source (17; 27; 37; 47; 57) d'un milieu de détection, qui peut conduire la ligne de détection (12; 22; 32; 42; 52), la source étant reliée à la ligne de détection (12; 22; 32; 42; 52) et pouvant alimenter le milieu de détection dans la ligne de détection (12; 22; 32; 42; 52) ;
- un détecteur (18; 28; 38; 48; 58) qui peut être relié à la ligne de détection (12; 22; 32; 42; 52) et qui peut détecter une interruption de ligne; et
- une unité d'évaluation (50) qui peut être reliée au détecteur de manière à transmettre des informations.

15. Système de surveillance selon la revendication 14, dans lequel la source est agencée pour injecter de l'air comprimé dans la ligne de détection (12; 22; 42) et le détecteur (18; 28; 48) est conçu comme un capteur de pression; ou dans lequel la source est agencée pour appliquer une tension électrique à la ligne de détection (32) et le détecteur (38) est agencé pour surveiller cette tension.

16. Système de surveillance selon l'une des revendications 14 ou 15, dans lequel l'unité d'évaluation (50) détecte un comportement erroné de la chaîne porte-câbles (1) lorsque le détecteur (58) détecte une interruption de la ligne de détection (52) afin de déclencher une mesure de protection.

17. Système de surveillance selon l'une des revendications 14 à 16, dans lequel les supports sont conçus comme des composants séparés pouvant être reliés aux maillons ou aux segments (14; 24; 34) de la chaîne porte-câbles (1), en particulier comme des séparateurs (16; 26; 36).
